Europäisches Patentamt

European Patent Office

Office européen des brevets

(19)

(11) **EP 0 583 815 B1**

(12) **EUROPEAN PATENT SPECIFICATION**

(45) Date of publication and mention
of the grant of the patent:
**09.10.1996 Bulletin 1996/41**

(51) Int Cl.[6]: **H03F 3/45**

(21) Application number: **93202146.2**

(22) Date of filing: **22.07.1993**

(54) **Common-mode signal sensor**

Gleichtaktsignalsensor

Détecteur de signaux de mode commun

(84) Designated Contracting States:
**DE FR GB IT NL**

(30) Priority: **30.07.1992 EP 92202351**

(43) Date of publication of application:
**23.02.1994 Bulletin 1994/08**

(73) Proprietor: **Philips Electronics N.V.**
**5621 BA Eindhoven (NL)**

(72) Inventor: **Rijns, Johannes J.F.,**
**c/o INT. OCTROOIBUREAU B.V.**
**NL-5656 AA Eindhoven (NL)**

(74) Representative: **Schoonheijm, Harry Barend et al**
**INTERNATIONAAL OCTROOIBUREAU B.V.,**
**Prof.Holstlaan 6**
**5656 AA Eindhoven (NL)**

(56) References cited:
**US-A- 4 918 398**

• **IEEE JOURNAL OF SOLID-STATE CIRCUITS.
vol. 19, no. 6 , December 1984 , NEW YORK US
pages 912 - 918 A. DE LA PLAZA ET AL
'POWER-SUPPLY REJECTION IN
DIFFERENTIAL SWITCHED-CAPACITOR
FILTERS'**
• **IBM TECHNICAL DISCLOSURE BULLETIN. vol.
16, no. 10 , March 1974 , NEW YORK US pages
3227 - 3228 W.CORDARO 'COMPLEMENTARY
FET DIFFERENTIAL AMPLIFIER'**

## Description

The invention relates to a common-mode signal sensor for supplying a common-mode signal in response to a difference signal, comprising: a first input terminal and a second input terminal for receiving the difference signal, an output terminal for supplying the common-mode signal, a first and a second transistor, each having a first main electrode, a second main electrode and a control electrode, the first main electrodes of the first and the second transistor being interconnected in a first node and the control electrode of the first transistor being coupled to the first input terminal, a first current source coupled to the first node to supply a first bias current, a third and a fourth transistor, each having a first main electrode, a second main electrode and a control electrode, the first main electrodes of the third and the fourth transistor being interconnected in a second node and the control electrode of the fourth transistor being coupled to the second input terminal, and a second current source coupled to the second node to supply a second bias current.

Such a common-mode signal sensor is known from the article "CMOS Voltage to Current Transducers", IEEE Transactions on Circuits and Systems, Vol. CAS-32, No. 11, November 1985, pp. 1097-1104, Figure 6. Common-mode signal sensors are used in common-mode rejection circuits for operational amplifiers, transconductors and similar electronic circuits. A known technique for measuring the common-mode signal content of a difference signal utilises the voltage on the node common to the first main electrodes of a standard differential pair whose control electrodes are arranged to receive the difference signal. This arrangement has the drawback that said voltage contains not only the common-mode signal but also the threshold voltage of the transistors used and further a part of the difference signal. The common-mode signal sensor known from said article employs two differential pairs. The first and the second transistor with the first current source constitute the first differential pair. The third and the fourth transistor with the second current source constitute the second differential pair. The control electrodes of the first and the fourth transistor are connected to the first and the second input terminal and receive the input signal whose common-mode voltage is to be measured. In a third node the control electrodes and the second main electrodes of the second and the third transistor are all connected to a third current source supplying a current equal to that of the first and the second current source. The voltage on the third node is a measure of the common-mode voltage of the input signal and no longer contains the threshold voltage of the transistors. However, this common-mode signal sensor has the drawback of a limited difference signal range because the voltages on the first and the second node do not increase symmetrically with an increasing difference voltage on the input terminals.

It is an object of the invention to provide a common-mode signal sensor having a large difference signal range. To this end a common-mode signal sensor of the type defined in the opening paragraph is characterised in that the first and the second transistor are of a first conductivity type, the third and the fourth transistor are of a second conductivity type opposite to the first conductivity type, the control electrode of the third transistor is coupled to the first input terminal, the control electrode of the second transistor is coupled to the second input terminal, and the common-mode signal sensor further comprises: a fifth transistor of the first conductivity type having a first main electrode, which is connected to the first node, and having a second main electrode and a control electrode, which are connected to the output terminal, and a sixth transistor of the second conductivity type having a first main electrode, which is connected to the second node, and having a second main electrode and a control electrode, which are connected to the output terminal.

The differential pairs are of opposite conductivity types and are both connected to the input terminals. The fifth and the sixth transistor function as a voltage divider for the common-mode voltages on the first and the second node, the components therein caused by the threshold voltages of the differential pairs being cancelled by the threshold voltages of the fifth and the sixth transistor.

It is to be noted that Figure 3 of United States Patent US 4,780,688 discloses a circuit which bears much resemblance to the common-mode signal sensor in accordance with the invention. However, in the circuit disclosed therein the second node is connected to the second current source and to the first main electrode of the sixth transistor *via* a resistor. Moreover, the output terminal is not connected to the node of the second main electrodes and the control electrodes of the fifth and the sixth transistor. As a matter of fact, this known circuit is not a common-mode signal sensor but a circuit for increasing the slew rate of the differential amplifier formed by the third and the fourth transistor.

These an other aspects of the invention will now be described and illustrated with reference to the accompanying drawings, in which

Figure 1 shows a circuit diagram of a common-mode signal sensor in accordance with the invention in an embodiment comprising unipolar transistors,
Figure 2 shows a circuit diagram of a common-mode signal sensor in accordance with the invention in an embodiment comprising bipolar transistors,
Figure 3 shows a circuit diagram of an operational amplifier comprising a common-mode rejection circuit using a common-mode signal sensor in accordance with the invention.

In these Figures parts having the same function or purpose bear the same references.

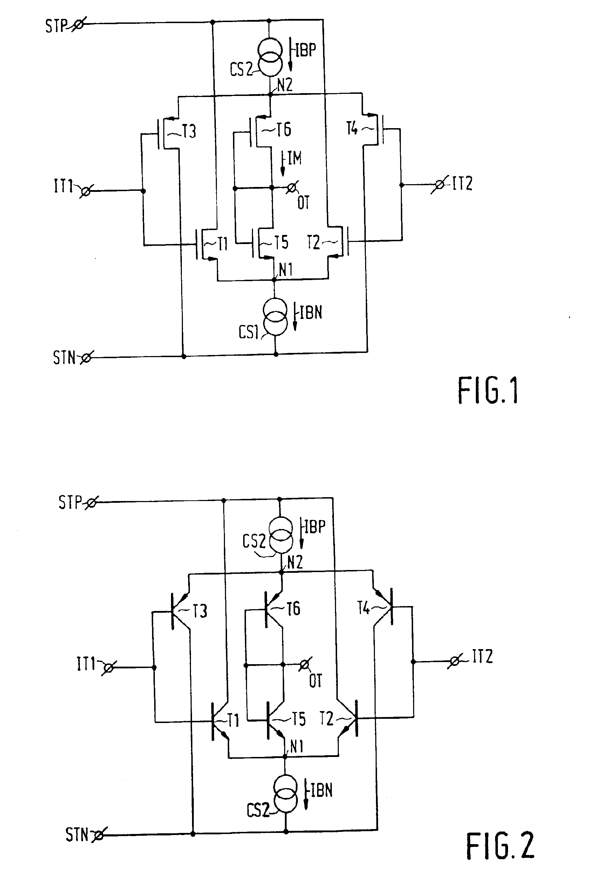

Figure 1 shows a common-mode signal sensor in accordance with the invention comprising unipolar transistors whose source, drain and gate correspond to the first main electrode, the second main electrode and the control electrode formed respectively. NMOS transistors T1 and T2 form a first differential pair. The transistors T1 and T2 have their source electrodes interconnected in a first node N1. The first node N1 is connected to a negative supply terminal STN *via* a first current source CS1 drawing a bias current IBN from the first node N1. The drains of the transistors T1 and T2 are connected, for example, directly to a positive supply terminal STP. However, if desired the drains may alternatively be connected to the positive supply terminal STP *via* a load, such as a resistor or an input branch of a current mirror. The gate of the transistor T1 is connected to a first input terminal IT1. The gate of the transistor T2 is connected to a second input terminal IT2. A second differential pair is formed by the PMOS transistors T3 and T4 having their sources interconnected in a second node N2. The second node N2 is connected to the positive supply terminal STP *via* a second current source CS2 supplying a bias current IBP to the second node N2. The gates of the transistors T3 and T4 are connected to the first input terminal IT1 and the second input terminal IT2 respectively. The drains of the transistors t3 and T4 are connected to the negative supply terminal STN but may alternatively be connected to this terminal *via* a load. Moreover, the first node n1 is connected to the source of an NMOS transistor T5 having the same threshold voltage as the transistors T1 and T2. The gate and the drain of the transistor T5 are both connected to an output terminal OT. The second node N2 is further connected to the source of a PMOS transistor T6 having the same threshold voltage as the transistors T3 and T4 and having its gate and drain connected to the output terminal OT.

It is now assumed that a difference signal Vin is applied to the input terminals, the voltage Vi1 on the first input terminal IT1 and the voltage Vi2 on the second input terminal IT2 complying with:

$$Vi1 = Vcm + Vin/2 \qquad (1)$$

$$Vi2 = Vcm + Vin/2 \qquad (2)$$

In these equations Vcm is the common-mode component of the difference voltage Vin. In order to simplify the analysis it is further assumed that all the transistors operate in the saturated mode, so that the relationship between the drain current I and the gate-source voltage Vgs is defined by the equation:

$$I = K(Vgs\text{-}Vt)^2 \qquad (3)$$

Here, Vt is the threshold voltage of the transistor and K is a transconductance parameter which depends *inter alia* on the width-length ratio (W/L) of the transistor. The NMOS differential pair T1, T2 supplies a difference current Ioutn, *i.e.* the difference between the drain currents of the transistors t1 and T2, which is a function of the difference voltage Vin. This function, expressed in terms of Gmn, becomes:

$$Ioutn = Gmn * Vin \qquad (4)$$

It is further assumed that a current IM flows through the transistors T5 and T6, which current is not constant but depends on the instantaneous voltage difference Vin. This results in a current IBN - IM through the transistors T1 and T2 together. The current flowing through T1 is now equal to half the current IBN - IM and half the current Ioutn. In accordance with equation (3) the current through the transistor T1 then complies with:

$$(Gmn * Vin)/2 + (IBN - IM)/2 = Kn (Vgs1 - Vtn)^2 \qquad (5)$$

Here, Vgs1 is the gate-source voltage of the transistor T1, Kn is the transconductance parameter, and Vtn is the threshold voltage of the NMOS transistors. The voltage VN1 on the first node N1 is equal to:

$$VN1 = Vi1 - Vgs1 \qquad (6)$$

Elimination of Vgs1 from equation (5), substitution of Vi1 by the right-hand member of equation (1), and insertion into

equation (6) yield:

$$VN1 = Vcm+Vin/2-Vtn-SQRT\{[(IBN - IM) + Gmn * Vin]/2Kn\} \qquad (7)$$

The output terminal OT carries a voltage VOT which is the sum of the gate-source voltage Vgs5 of the transistor T5 and the voltage VN1 on the first node N1:

$$VOT = VN1 + Vgs5 \qquad (8)$$

Since the current through the transistor T5 is equal to IM, equation (8) may be re-written by means of equation (3) to give:

$$VOT - VN1 = Vtn + SQRT\{IM/Kn\} \qquad (9)$$

In an entirely similar way the following equations can be found for the differential pair T3, T4 and the associated transistor T6:

$$VN2 = Vcm-Vin/2+Vtp+SQRT\{[(IBP - IM) + Gmp * Vin]/2Kp\} \qquad (10)$$

$$VN2 - VOT = Vtp + SQRT\{IM/Kp\} \qquad (11)$$

where Vtp, Gmp and Kp of the PMOS transistors T4, T3 and T6 take the place of Vtn, Gmn and Kn of the NMOS transistors T1, T2 and T5. By choosing Kp = Kn it follows from equations (9) and (11) that:

$$2VOT = (VN1 + VN2) + (Vtn - Vtp) \qquad (12)$$

As a result of the choice IBN = IBP the difference currents Ioutn and Ioutp become equal to each other, so that Gmn * Vin and Gmp * Vin also become equal to each other. As a consequence, the terms SQRT in equations (7) and (10) are equal to each other. Addition of equations (7) and (10) then yields:

$$VN1 + VN2 = 2Vcm + (Vtp -Vtn) \qquad (13)$$

Combining equations (12) and (13) results in VOT = Vcm. This means that the voltage on the output terminal OT is equal to the common-mode voltage on the input terminals IT1 and IT2 for any value of Vin.

The transconductance parameters Kn and Kp can be equalised by an appropriate choice of the W/L ratio of the NMOS transistors and of the W/L ratio of the PMOS transistors. The common-mode signal sensor even functions in the case of non-compliance with Kp = Kn and/or IBN = IBP. The output voltage VOT will then exhibit a certain fluctuation as function of Vin.

Figure 2 shows a common-mode signal sensor comprising bipolar transistors whose emitter, collector and base correspond to the first main electrode, the second main electrode and the control electrode. The PMOS transistors have been replaced by PNP transistors and the NMOS transistors by NPN transistors. However, the relationship between the current through the transistor and the base-emitter voltage is not as defined by equation (3) but eventually the result is the same. It is to be noted that instead of the requirement Kn = Kp other parameters should be equal to each other for bipolar transistors. In this case the requirements βp = βn and Isp = Isn should be met, where β is the current gain factor and Is is the saturation current of the bipolar transistor.

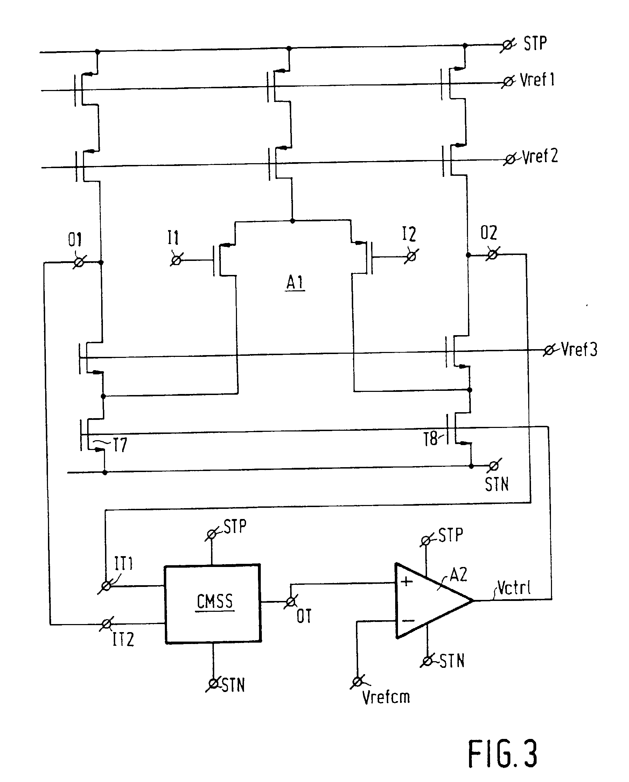

Figure 3 shows a use of a common-mode signal sensor in accordance with the invention. The common-mode signal sensor is referenced CMSS and is internal as shown in Figure 1. The input terminals IT1 and IT2 are respectively connected to the output terminals O2 and O1 of an amplifier A1. The common-mode voltage on the output terminal OT is compared with a common-mode reference voltage Vrefcm in an amplifier A2 to supply a control voltage Vctrl to the transistors T7 and T8 of the amplifier A1, which transistors are each arranged as a controllable current source. In this way the common-mode voltage on the outputs O1 and O2 is controlled towards the desired reference voltage Vrefcm.

**Claims**

1. A common-mode signal sensor for supplying a common-mode signal in response to a difference signal, comprising: a first input terminal (IT1) and a second input terminal (IT2) for receiving the difference signal, an output terminal (OT) for supplying the common-mode signal, a first (T1) and a second (T2)transistor, each having a first main electrode, a second main electrode and a control electrode, the first main electrodes of the first (T1) and the second (T2) transistor being interconnected in a first node (N1) and the control electrode of the first transistor (T1) being coupled to the first input terminal (IT1), a first current source (CS1) coupled to the first node (N1) to supply a first bias current (IBN), a third (T3) and a fourth (T4) transistor, each having a first main electrode, a second main electrode and a control electrode, the first main electrodes of the third (T3) and the fourth (T4) transistor being interconnected in a second node (N2) and the control electrode of the fourth transistor (T4) being coupled to the second input terminal (IT2), and a second current source (CS2) coupled to the second node (N2) to supply a second bias current (IBP), characterised in that the first (T1) and the second (T2) transistor are of a first conductivity type, the third (T3)and the fourth (T4) transistor are of a second conductivity type opposite to the first conductivity type, the control electrode of the third transistor (T3) is coupled to the first input terminal (IT1), the control electrode of the second transistor (T2) is coupled to the second input terminal (IT2), and the common-mode signal sensor further comprises: a fifth transistor (T5) of the first conductivity type having a first main electrode, which is connected to the first node (N1), and having a second main electrode and a control electrode, which are connected to the output terminal (OT), and a sixth transistor (T6) of the second conductivity type having a first main electrode, which is connected to the second node (N2), and having a second main electrode and a control electrode, which are connected to the output terminal (OT).

2. A common-mode signal sensor as claimed in Claim 1, characterised in that the first (T1), the second (T2) and the fifth (T5) transistor are substantially identical to one another, and the third (T3),the fourth (T4) and the sixth (T6) transistor are substantially identical to one another.

3. A common-mode signal sensor as claimed in Claim 1 or 2, characterised in that the first bias current (IBN) is substantially equal to the second bias current (IBP).

4. A common-mode signal sensor as claimed in Claim 2 or 3, characterised in that by an appropriate choice of transistor parameters defining the proportionality factor between a current variation in the main current path of the transistor and a voltage variation between the control electrode and the first main electrode of the transistor the proportionality factor is substantially the same for the first to the sixth transistor (T1...T6).

**Patentansprüche**

1. Gleichtaktsignalsensor zum Liefern eines Gleichtaktsignals in Reaktion auf ein Differenzsignal, mit: einer ersten Eingangsklemme (IT1) und einer zweiten Eingangsklemme (IT2) zum Empfangen des Differenzsignals, einer Ausgangsklemme (OT) zum Liefern des Gleichtaktsignals, einem ersten (T1) und einem zweiten (12)Transistor, von denen jeder eine erste Hauptelektrode, eine zweite Hauptelektrode und eine Steuerelektrode hat, wobei die ersten Hauptelektroden des ersten (T1) und des zweiten (T2) Transistors in einem ersten Knotenpunkt (N1) miteinander verbunden sind und die Steuerelektrode des ersten Transistors (T1) mit der ersten Eingangsklemme (IT1) gekoppelt ist, einer mit dem ersten Knotenpunkt (N1) gekoppelten ersten Stromquelle (CS1) zur Lieferung eines ersten Ruhestroms (IBN), einem dritten (T3) und einem vierten (T4) Transistor, von denen jeder eine erste Hauptelektrode, eine zweite Hauptelektrode und eine Steuerelektrode hat, wobei die ersten Hauptelektroden des dritten (T3) und des vierten (T4) Transistors in einem zweiten Knotenpunkt (N2) miteinander verbunden sind und die Steuerelektrode des vierten Transistors (T4) mit der zweiten Eingangsklemme (IT2) gekoppelt ist, und einer zweiten Stromquelle (CS2), die mit dem zweiten Knotenpunkt (N2) gekoppelt ist, um einen zweiten Ruhestrom (IBP) zu liefern, dadurch gekennzeichnet, daß der erste (T1) und der zweite (T2) Transistor von einem ersten Leitungstyp sind, der dritte (T3) und der vierte (T4) Transistor von einem zweiten, dem ersten Leitungstyp entgegengesetzten Leitungstyp sind, die Steuerelektrode des dritten Transistors (T3) mit der ersten Eingangsklemme (IT1) gekoppelt ist, die Steuerelektrode des zweiten Transistors (T2) mit der zweiten Eingangsklemme (IT2) gekoppelt ist, und der Gleichtaktsignalsensor weiterhin umfaßt: einen fünften Transistor (T5) des ersten Leitungstyps mit einer ersten Hauptelektrode, die mit dem ersten Knotenpunkt (N1) verbunden ist, einer zweiten Hauptelektrode und einer Steuerelektrode, die mit der Ausgangsklemme (OT) verbunden sind, und einen sechsten Transistor (T6) vom zweiten Leitungstyp mit einer ersten Hauptelektrode, die mit dem zweiten Knotenpunkt (N2) verbunden ist, und einer zweiten Hauptelektrode und einer Steuerelektrode, die mit der Ausgangsklemme (OT) verbunden sind.

EP 0 583 815 B1

**2.** Gleichtaktsignalsensor nach Anspruch 1, <u>dadurch gekennzeichnet,</u> daß der erste (T1), der zweite (T2) und der fünfte (T5) Transistor nahezu zueinander identisch sind und der dritte (T3), der vierte (T4) und der sechste (T6) Transistor nahezu zueinander identisch sind.

**3.** Gleichtaktsignalsensor nach Anspruch 1 oder 2, <u>dadurch gekennzeichnet,</u> daß der erste Ruhestrom (IBN) nahezu gleich dem zweiten Ruhestrom (IBP) ist.

**4.** Gleichtaktsignalsensor nach Anspruch 2 oder 3, <u>dadurch gekennzeichnet</u> daß bei einer geeigneten Wahl von Transistorparametern, die den Proportionalitätsfaktor zwischen einer Stromänderung im Hauptstrompfad des Transistors und einer Spannungsänderung zwischen der Steuerelektrode und der ersten Hauptelektrode des Transistors definieren, der Proportionalitätsfaktor für den ersten bis sechsten Transistor (T1...T6) nahezu der gleiche ist.

## Revendications

**1.** Détecteur de signaux de mode commun pour fournir un signal de mode commun en réponse à un signal différentiel, comprenant: une première borne d'entrée (IT1) et une deuxième borne d'entrée (IT2) pour la réception du signal différentiel, une borne de sortie (OT) pour délivrer le signal de mode commun, un premier transistor (T1) et un deuxième transistor (T2) présentant chacun une première électrode principale, une deuxième électrode principale et une électrode de commande, les premières électrodes principales des premier (T1) et deuxième (T2) transistors étant interconnectées dans un premier noeud (N1) et l'électrode de commande du premier transistor (T1) étant couplée à la première borne d'entrée (IT1), une première source de courant (SC1) couplée au premier noeud (N1) pour fournir un premier courant de polarisation (IBN), un troisième transistor (T3) et un quatrième transistor (T4) présentant chacun une première électrode principale, une deuxième électrode principale et une électrode de commande, les premières électrodes principales des troisième (T3) et quatrième (T4) transistors étant interconnectées dans un deuxième noeud (N2) et l'électrode de commande du quatrième transistor (T4) étant couplée à la deuxième borne d'entrée (IT2), et une deuxième source de courant (CS2) couplée au deuxième noeud (N2) pour fournir un deuxième courant de polarisation (IBP), caractérisé en ce que les premier (T1) et deuxième (T2) transistors sont d'un premier type de conductivité, les troisième (T3) et quatrième (T4) transistors sont d'un deuxième type de conductivité opposé au premier type de conductivité, l'électrode de commande du troisième transistor (T3) est couplée à la première borne d'entrée (IT1), l'électrode de commande du deuxième transistor (T2) est couplée à la deuxième borne d'entrée (IT2) et le détecteur de signaux de mode commun comprend en outre: un cinquième transistor (T5) du premier type de conductivité présentant une première électrode principale, qui est connectée au premier noeud (N1), et présentant une deuxième électrode principale et une électrode de commande, qui sont connectées à la borne de sortie (OT), et un sixième transistor (T6) du deuxième type de conductivité présentant une première électrode principale, qui est connectée au deuxième noeud (N2) et présentant une deuxième électrode principale et une électrode de commande, qui sont connectées à la borne de sortie (OT).

**2.** Détecteur de signaux de mode commun selon la revendication 1, caractérisé en ce que les premier (T1), deuxième (T2) et cinquième (T5) transistors sont pratiquement identiques les uns aux autres, et les troisième (T3) et quatrième (T4) et sixième (T6) transistors sont pratiquement identiques les uns aux autres.

**3.** Détecteur de signaux de mode commun selon la revendication 1 ou 2, caractérisé en ce que le premier courant de polarisation (IBN) est pratiquement égal au deuxième courant de polarisation (IBP).

**4.** Détecteur de signaux de mode commun selon la revendication 2 ou 3, caractérisé en ce que par un choix approprié des paramètres de transistor définissant le facteur de proportionnalité entre une variation de courant dans le trajet de courant principal du transistor et une variation de tension entre l'électrode de commande et la première électrode principale du transistor, le facteur de proportionnalité est pratiquement le même pour les premier au sixième transistors (T1 ... T6).

6

FIG.1

FIG.2

FIG.3